# EUROPEAN PATENT APPLICATION

(11) **EP 4 687 074 A1**
(43) Date of publication of application: **04.02.2026**
(21) Application number: 24223765.9
(22) Date of filing: 30.12.2024
(51) Int. Cl.: G06N 3/063

(54) **NEURAL NETWORK DEVICE AND OPERATING METHOD THEREOF**

(30) Priority: 31.07.2024 KR 20240101717
(71) Applicant: Pebble Square, Inc., Seongnam-si, Gyeonggi-do 13488 (KR)
(72) Inventor: LEE, Choong Hyun, 31226 Chungcheongnam-do (KR); MOON, Soung Hyun, 03903 Seoul (KR)
(74) Representative: Zacco Sweden AB

(57) **Abstract**

A neural network device includes: a digital-to-analog converter configured to convert a digital input to an analog input of either voltage or current; a cell array including a plurality of memory cells arranged in a plurality of bit lines and a plurality of word lines and configured to store a weight of a neural network, and configured to perform an operation on the analog input that is input through the word lines and output an analog output of any one of current and voltage, through the bit lines; an analog-to-digital converter configured to convert the analog output into a digital output; and at least one processor electrically connected to the digital-to-analog converter and the analog-to-digital converter and configured to control the digital input and the digital output.

## Description

### BACKGROUND

### 1. Field

The present disclosure relates to a neural network device and a method of operating the same, and more specifically, to a method of performing precise bit operations using a neural network device with a relatively small bit resolution.

### 2. Description of the Related Art

Artificial neural networks imitate biological neural networks. They may be trained using a large amount of input data, and are used to estimate or approximate results that are difficult to derive with general techniques. Artificial neural networks have layers of interconnected neurons that exchange signals, and synapses have weights determined based on learning or experience.

On the other hand, computing in memory (CIM) devices that perform analog calculations process data inside a memory, which minimizes data movement between the memory and a processor, thereby improving calculation speed. However, when implemented as an edge computing device, there are size limitations, preventing precise calculation.

The above-described background technology is technical information that the inventor possessed for deriving the present disclosure or acquired in the process of deriving the present disclosure, and cannot necessarily be said to be known art disclosed to the general public before filing the application for the present disclosure.

### SUMMARY

The present disclosure provides a neural network device and a method of operating the same. The problem to be solved by the present disclosure is not limited to the technical problems mentioned above, and other technical problems not mentioned may be clearly understood by those skilled in the art from the description of the present disclosure. The present disclosure will be understood more clearly by the examples. In addition, it will be appreciated that the problems and advantages to be solved by the present disclosure may be realized by the means and combinations thereof indicated in the patent claims.

However, the above objective is an example, and the scope of the disclosure is not limited by the above objective.

Additional aspects will be set forth in part in the description which follows and, in part, will be apparent from the description, or may be learned by practice of the presented embodiments of the disclosure.

As a means to solve the above-described technical problem, according to a first aspect of the present disclosure, there is provided a neural network device including: a digital-to-analog converter configured to convert a digital input to an analog input of either voltage or current; a cell array including a plurality of memory cells arranged in a plurality of bit lines and a plurality of word lines and configured to store a weight of a neural network, and configured to perform an operation on the analog input that is input through the word lines and output an analog output of any one of current and voltage, through the bit lines; an analog-to-digital converter configured to convert the analog output into a digital output; and at least one processor electrically connected to the digital-to-analog converter and the analog-to-digital converter and configured to control the digital input and the digital output, wherein the at least one processor is further configured to, based on a number of bits of the input signal and a digital-to-analog converter (DAC) bit resolution of the digital-to-analog converter, input one or more digital inputs including at least a portion of the input signal, to the digital-to-analog converter, and generate, based on the number of bits of the input signal and a cell bit resolution of the plurality of memory cells, an output signal by using at least one of digital outputs corresponding to an output of the bit lines.

According to a second aspect of the present disclosure, there is provided an operating method of a neural network device, the method including: generating, based on a number of bits of an input signal and a DAC bit resolution of a digital-to-analog converter, one or more digital inputs including at least a portion of the input signal; obtaining one or more digital outputs corresponding to the one or more digital inputs by using a cell array including a plurality of memory cells that store a weight of a neural network; and generating an output signal by using at least one of the digital outputs, based on the number of bits of the input signal and a cell bit resolution of the plurality of memory cells.

According to a third aspect of the present disclosure, there is provided a computer-readable recording medium having recorded thereon a program for executing the method according to the second aspect on a computer.

In addition, another method or another device for implementing the present disclosure, and a computer-readable recording medium recording a program for executing the method may be further provided.

Other aspects, features and advantages in addition to those described above will become apparent from the following drawings, claims and detailed description of the present disclosure.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a diagram illustrating implementation of a neural network system according to an embodiment;
FIGS. 2 and 3 are diagrams for comparing a von Neumann architecture with a computing in memory (CIM) architecture according to an embodiment of the present disclosure;
FIG. 4 is a diagram illustrating a neural network device according to an embodiment of the present disclosure;
FIGS. 5A to 5B are diagrams for describing a method of operating a cell array, according to an embodiment;
FIGS. 6A to 6B are diagrams for comparing a vector-matrix multiplication and an operation performed on a cell array according to an embodiment;
FIG. 7 is a diagram to describe an example in which a convolution operation is performed in a cell array according to an embodiment;
FIG. 8 is a diagram to describe a method of operating a neural network device, according to an embodiment of the present disclosure;
FIG. 9 is a diagram to describe a digital input according to an embodiment of the present disclosure;
FIG. 10 is a diagram to describe a method of generating an output signal, according to an embodiment of the present disclosure;
FIG. 11 is a diagram to describe a digital input according to another embodiment of the present disclosure;
FIG. 12 is a diagram to describe a method of generating an output signal, according to another embodiment of the present disclosure;
FIG. 13 is a diagram to describe a method of operating a neural network device, according to another embodiment of the present disclosure;
FIG. 14 is a diagram to describe a method of generating an output signal, according to an embodiment of the present disclosure;
FIG. 15 is a diagram to describe a method of generating an output signal, according to another embodiment of the present disclosure;
FIG. 16 is a flowchart of a method of operating a neural network device, according to an embodiment of the present disclosure; and
FIG. 17 is a block diagram of a neural network device according to another embodiment of the present disclosure.

### DETAILED DESCRIPTION

In the description of the present disclosure, the detailed description of known techniques which might unnecessarily obscure the subject matter of the present disclosure will be omitted or made in brief. Unless defined differently, all terms used in the description have the same meaning as generally understood by those skilled in the art.

Phrases such as "according to an embodiment," "related to an embodiment," or "according to implementation of an embodiment" in this specification do not necessarily all refer to the same embodiment.

As the embodiments allow for various changes and many different forms, particular embodiments will be illustrated in the drawings and described in detail in the written description. However, this is not intended to limit the present disclosure to particular modes of practice, and it is to be appreciated that all changes, equivalents, and substitutes that do not depart from the spirit and technical scope of the present disclosure are encompassed in the present disclosure. The terms used in the specification are merely used to describe the embodiments and are not intended to limit the embodiments.

The terms used in this specification are those general terms currently widely used in the art in consideration of functions in regard to the disclosure, but the terms may vary according to the intention of those of ordinary skill in the art, precedents, or new technology in the art. Also, specified terms may be selected by the applicant, and in this case, the detailed meaning thereof will be described in the detailed description. Thus, the terms used in the embodiments should be understood not as simple names but based on the meaning of the terms and the overall description of the embodiments.

Some embodiments of the present disclosure may be represented by functional block configurations and various processing steps. Some or all of these functional blocks may be implemented in various numbers of hardware and/or software configurations that perform specific functions. For example, the functional blocks of the present disclosure may be implemented by one or more microprocessors, or may be implemented by circuit configurations for certain functions.

Additionally, for example, functional blocks of the present disclosure may be implemented in various programming or scripting languages. Functional blocks may be implemented as algorithms running on one or more processors. Furthermore, the present disclosure could employ any number of conventional techniques for electronics configuration, signal processing and/or control, data processing and the like.

The terms such as "database", "element", "means", "configuration" are used broadly and are not limited to mechanical or physical embodiments. Also, in the specification, the term "units" or "...modules" denote units or modules that process at least one function or operation, and may be realized by hardware, software, or a combination of hardware and software.

Furthermore, the connecting lines, or connectors shown in the various figures presented are intended to represent exemplary functional relationships and/or physical or logical couplings between the various elements. It should be noted that many alternative or additional functional relationships, physical connections or logical connections may be present in a practical device.

Additionally, terms including ordinal numbers such as 'first' or 'second' used in this specification may be used to describe various components, but the components should not be limited by the terms. The above terms are used only to distinguish one component from another.

Additionally, some components in the drawing may be shown with their size or proportions somewhat exaggerated. Additionally, components illustrated in one drawing may not be illustrated in other drawings.

Throughout the specification, 'embodiment' is an arbitrary division for easily describing the present disclosure, and each embodiment does not need to be mutually exclusive. For example, configurations disclosed in an embodiment may be applied and/or implemented in another embodiment, and may be applied and/or implemented with changes without departing from the scope of the present disclosure.

Additionally, the terms used in the present disclosure are for describing the embodiments and are not intended to limit the embodiments. In the present disclosure, the singular form also includes the plural form unless otherwise specified.

Below, with reference to the attached drawings, embodiments of the present disclosure will be described in detail so that those skilled in the art can easily implement them. However, the embodiments of the present disclosure may be implemented in various different forms and are not limited to the embodiments described in the present disclosure.

Hereinafter, the present disclosure will be described in detail with reference to the drawings.

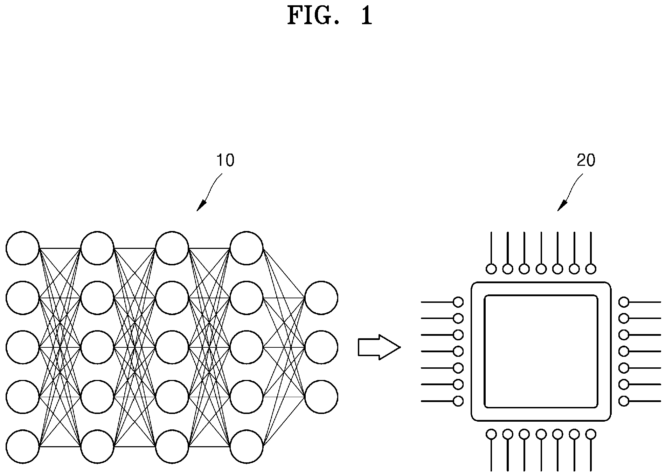

FIG. 1 is a diagram illustrating implementation of a neural network system according to an embodiment.

Referring to FIG. 1, a trained neural network 10 and a device 20 on which the neural network 10 is implemented are illustrated.

That the neural network 10 has been trained indicates that a weight of each layer of the neural network 10 has been determined based on a plurality of pieces of learning data. If weights that are a result of training of the neural network 10 are stored in a central cloud server, a cloud computing device that uses the neural network 10 may communicate with the central cloud server to transmit an input value from and output an output value to the neural network 10. In this case, even if the neural network 10 is very complex or large-scale, the output value may be used without any problem by the cloud computing device.

However, if the device 20 is an edge computing device that processes data on the device itself without communicating with a central cloud server, the weight of the neural network 10 determined through learning is stored in the device, which is an actual hardware device, specifically, weights are stored in memory cells constituting a cell array of the device 20. The device 20 may be a neuromorphic chip.

Neuromorphic chips are hardware that mimics human brain function by creating circuits that mimic the shape of neurons. In other words, a neuromorphic chip refers to a computer chip that mimics the structure of the nervous system. Neuromorphic chips consist of only circuits necessary for neural network calculations, and thus may achieve hundreds of times more gains in terms of power, area, and speed. Neuromorphic chips mimic the way the brain works and thus the structure thereof connecting neurons and synapses is configured in parallel, and may save energy by connecting and disconnecting the electrical connection of the neuromorphic chips when data is not being processed. For example, the von Neumann architecture of the existing computer is excellent for executing precisely written programs because data is processed sequentially when data is input, but there are limitations in power consumption and low efficiency in pattern recognition and real-time recognition. On the other hand, neuromorphic chips use analog operations in which data gradually changes into various states rather than digital ones such as 0 or 1. In other words, artificial neurons configured in parallel operate in an event-driven manner without clock operation. Therefore, atypical text, voice, and video that are difficult for existing computers to recognize intuitively may be efficiently processed.

In an embodiment, when input data such as an image, voice, or electromagnetic wave is input to a neuromorphic chip, certain output data may be output through an operation on the input data within the neuromorphic chip. Data input to the neuromorphic chip is not limited to the above-described images, voices, or electromagnetic waves, and may include various types of data such as video and text.

A neuromorphic device according to an embodiment may be implemented with an edge artificial intelligence (Al) chip. Edge AI refers to a technology that runs AI algorithms on hardware devices using edge computing based on data generated from a system. AI processing is mainly performed in cloud-based data centers that require enormous computing capacity and is highly server-dependent. On the other hand, when edge AI is used, AI algorithm calculations are performed locally, reducing dependence on the cloud (server), thereby reducing communication costs, and protecting privacy as sensitive personal information is not transmitted to the cloud. Therefore, by configuring a neuromorphic device with an edge AI Chip, not only may costs be reduced and security improved, but calculations may be performed immediately within the same hardware, making it possible to implement a system with high responsiveness.

A state value of each weight in the neural network 10 may be diverse (e.g., 128 states), and memory cells of a cell array implemented in the device 20 may be multi-bit-memory cells (e.g., 8 bit) and store a state value of a weight. In order to perform an operation on data input from the device 20, a cell array of a neural network is to include memory cells with a state value equal to or greater than a resolution of input data, that is, a state value equal to or greater than the number of bits of the input data, and a digital-to-analog converter of the device 20 also needs to have a resolution equal to or greater than the number of bits of the input data.

However, when a neural network is implemented with a high-resolution memory cell, excessive costs may be incurred, and a high-resolution digital-to-analog converter occupies a relatively large area, which may unnecessarily increase the size of the device 20. Therefore, considering the size and cost of the device 20, a high-precision operation method (that is, processing data with a high number of bits) is needed even when the device 20 includes low-resolution components.

In the present specification, a 'cell bit resolution' refers to the number of different state values which a single memory cell may express, the number being expressed in the number of bits. For example, when a cell bit resolution of a memory cell is 7 bits, this may indicate that the memory cell may store any one of 128 distinct state values.

In the following description, the device 20 according to an embodiment of the present disclosure, that is, a neural network device, may be the neuromorphic device described above. In other words, the above-described neuromorphic device may function as a neural network device according to an embodiment of the present disclosure.

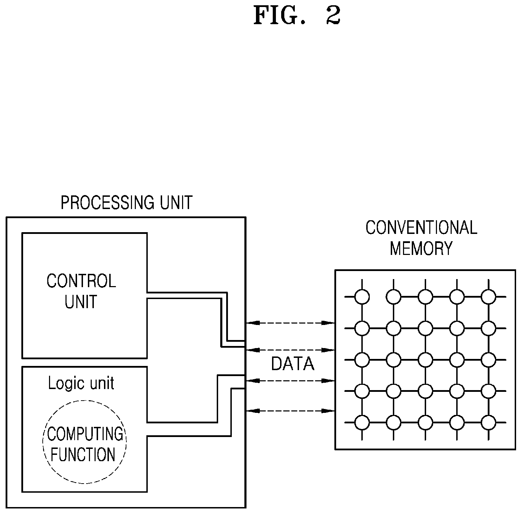

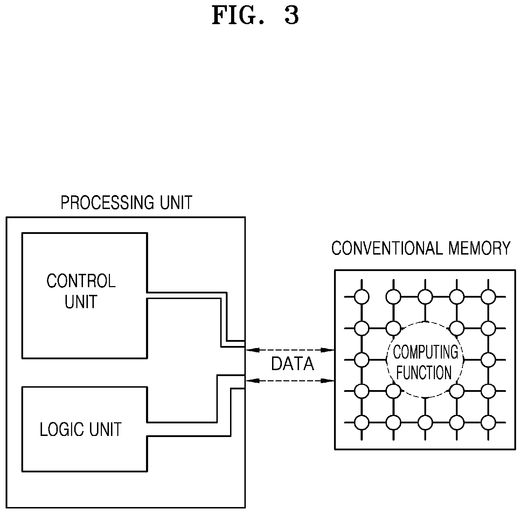

FIGS. 2 and 3 are diagrams for comparing a von Neumann architecture and a computing in memory (CIM) structure according to an embodiment of the present disclosure.

Referring to FIG. 2, the von Neumann architecture is a computer architecture proposed by John von Neumann and is a program-embedded computer architecture consisting of a typical three-level structure of a main memory, a central processing unit, and an input/output device.

The von Neumann architecture has the advantage of greatly improved versatility because only the software (program) needs to be changed without the need to rearrange the hardware (wires, etc.) when changing to another work in a computing device. However, as listed instructions are performed sequentially and the instructions consist of an operation of changing the value of a certain memory location, serious problems are generated in the design of high-speed computers. This is called the von-Neumann bottleneck phenomenon.

In order to solve the von Neumann bottleneck, as alternatives proposed are: the Harvard architecture that separates memory into a place where instructions are stored and a place where data is stored; the CIM architecture that not only stores data in memory but also performs data operations; and neuromorphic computing where numerous units with integrated calculation and memory functions are configured and connected in parallel like a mesh, using integrated circuits in the form of an artificial neural network that imitates the brain structure of higher animals, and then the units are operated in an event-driven manner, etc.

Referring to FIG. 3, it may be seen that the CIM architecture includes a processor and a memory with a computing function.

Unlike in the existing von Neumann architecture, where all data inside a memory is moved to the processor for calculation, in the CIM architecture, when an instruction of a processor is transmitted, the calculation is performed within the memory and only the result data is sent to the processor, without movement of a large amount of data. Thus, the von Neumann bottleneck may be effectively solved. Additionally, there is an advantage that power consumption is significantly lowered.

A neural network device according to an embodiment of the present disclosure may perform an operation using only on-chip memory without using external memory. For example, the neural network may perform an operation for each layer based on CIM using only on-chip memory without using external memory (e.g. off-chip memory, etc.), thereby performing calculations without memory update while processing an input signal. Specifically, the neural network device may perform CIM-based calculations in which each memory cell and the processor are directly connected.

However, the CIM-based AI chip has a structure in which calculations are performed directly within the internal memory rather than exchanging data with external memory, eliminating bottlenecks caused by data movement between traditional memory and computing devices. Through this, CIM-based AI chips may fundamentally solve the memory bandwidth problem. Additionally, this architecture provides the advantage of reducing power consumption and minimizing heat generation. A cell array of the neural network device according to an embodiment of the present disclosure may be configured with a memory that is implemented as multi-bits in order to maximize the operation of this CIM architecture. For example, a neural network device may be configured with a memory capable of implementing 7 bits (128 analog memory states). By configuring a neural network to have a large capacity, massive amounts of data may be processed with low power and high performance even when used for long periods of time, unlike typical CIM chips that have problems such as heat generation or performance degradation.

Meanwhile, on-chip memory may be implemented by a cell array. That is, the cell array may perform operations by receiving instructions from a processor, and the on-chip memory may achieve CIM operations as memory cells of the cell array are integrated. As an example, the processor may receive an input signal and obtain an output signal by driving a neural network device trained based on certain learning data.

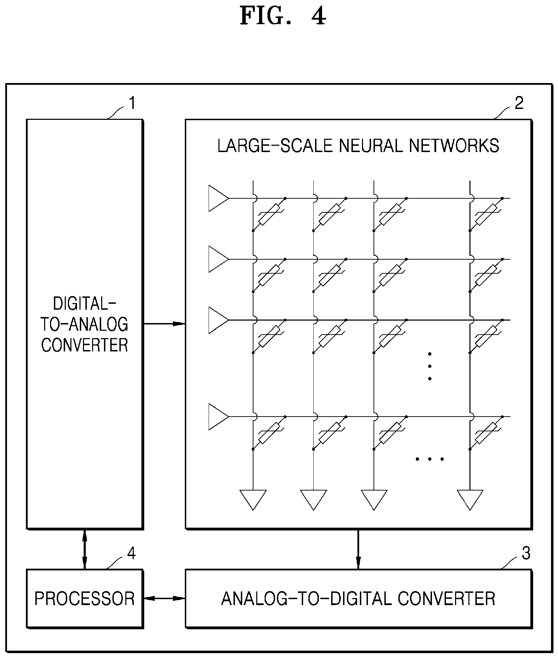

FIG. 4 is a diagram illustrating a neural network device according to an embodiment of the present disclosure.

The neural network device may be implemented with various types of devices such as personal computers (PCs), server devices, mobile devices, and embedded devices. Examples of the device may include a smartphone, a tablet device, an augmented reality (AR) device, an Internet of Things (loT) device, a self-driving car, robotics, a medical device, etc., that performs voice recognition, image recognition, and image classification, using a neural network, but is not limited thereto. Furthermore, the neural network device may correspond to a dedicated hardware accelerator (HW accelerator) mounted on the above device, and the neural network device may be a dedicated module for running the neural network, such as a neural processing unit (NPU) or a tensor processing unit (TPU), may be a hardware accelerator such as a neural engine, but is not limited thereto.

The neural network device may include a digital-to-analog converter 1, a cell array 2, an analog-to-digital converter 3, and a processor 4. In the neural network device illustrated in FIG. 4, only components related to the present embodiments are illustrated, and it will be obvious to a person skilled in the art that the neural network device may further include other general-purpose components in addition to the components illustrated in FIG. 4.

A neural network device according to an embodiment may include the digital-to-analog converter 1.

The digital-to-analog converter 1 according to an embodiment may convert an input signal having a digital value, into an analog signal. For example, an analog signal may be voltage or current. That is, the digital-to-analog converter 1 may convert a digital input into an analog input of either voltage or current. As an example, the digital-to-analog converter 1 may receive a digital voltage consisting of multi-bits, convert the same into an analog voltage corresponding to the number of bit lines, and apply the analog voltage to a plurality of bit lines.

The neural network device according to an embodiment may include the cell array 2 including a plurality of memory cells arranged in a plurality of bit lines and a plurality of word lines.

The plurality of word lines of the cell array 2 according to an embodiment may be connected to the digital-to-analog converter 1 and receive, from the digital-to-analog converter 1, an analog input obtained by converting a digital input.

As described above, the plurality of memory cells may store a weight of a neural network. As an example, when an analog input is input through each of the plurality of word lines of the cell array 2, a multiply and accumulate (MAC) operation is performed with the weight of the neural network stored in the plurality of memory cells so as to output an analog output through each of the plurality of words. Like the analog input, the analog output may be either a current or voltage signal.

The neural network device according to an embodiment may include the analog-to-digital converter 3.

The analog-to-digital converter 3 according to an embodiment may be connected to the plurality of bit lines of the cell array 2 and receive an analog output.

The analog-to-digital converter 3 according to an embodiment may convert the analog output into a digital output having a digital value. That is, the analog-to-digital converter 3 may convert the analog output, which is any one of voltage and current, into a digital output. As an example, the analog-to-digital converter 3 may receive an analog voltage output from the plurality of bit lines and convert the same into a digital input having a certain number of bits.

The processor 4 according to an embodiment may be electrically connected to the digital-to-analog converter 1 and the analog-to-digital converter 3, and may control digital inputs and digital outputs. The processor 4 may control a digital input based on an input signal or control an output signal based on a digital output.

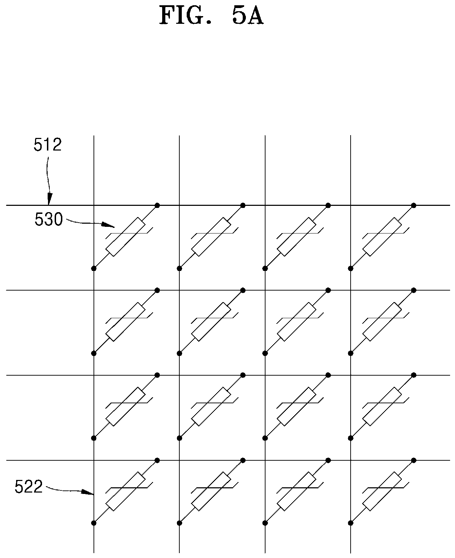

FIGS. 5A to 5B are diagrams for describing a method of operating a cell array, according to an embodiment.

Referring to FIG. 5A, the cell array may include a plurality of memory cells 530. Here, the memory cells 530 may be each an element having electrical conductance or a weight that changes depending on electrical pulses, such as voltage or current, applied to both ends thereof. For example, each memory cell 530 may include resistive crossbar memory arrays (RCA), and may include resistive RAM (ReRAM), ferroelectric RAM (FeRAM), phase-change RAM (PRAM), magnetic RAM (MRAM), or NAND/NOR flash memory, which may be implemented as a multi-level.

In an embodiment, in the cell array, a line 512 extending in a first direction (e.g., a horizontal direction), and a line 522 extending in a second direction (e.g., a vertical direction) that intersects the first direction may be provided. Hereinafter, for convenience of description, the line 512 extending in the first direction will be referred to as a row line, and the line 522 extending in the second direction will be referred to as a column line. The plurality of memory cells 530 may be disposed at respective intersections between the row lines 512 and the column lines 522 to connect the corresponding row line 512 and the corresponding column line 522 to each other.

The memory cell 530 may be implemented to have various characteristics, such as no abrupt change in resistance during set and reset operations, and an analog behavior in which conductivity gradually changes depending on the number of input electrical pulses. Specifically, a processor of the neural network device may apply a diversified voltage to the memory cell 530. Accordingly, a resistance value or a weight of the memory cell 530 may gradually change.

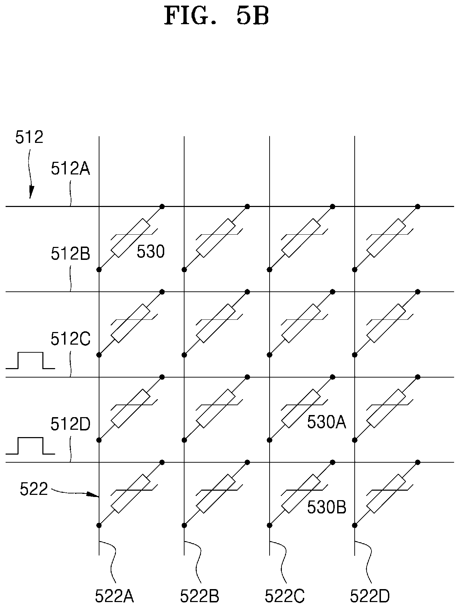

Operation of the above cell array is described with reference to FIG. 5B as follows. For convenience of description, sequentially from the top, the row line 512 may be referred to as a first row line 512A, a second row line 512B, a third row line 512C, and a fourth row line 512D, and in the order from the left, the column line 522 may be referred to as a first column line 522A, a second column line 522B, a third column line 522C, and a fourth column line 522D.

Referring to FIG. 5B, in an initial state, all of the plurality of memory cells 530 may be in a state of relatively low conductivity, that is, a high resistance state. When at least a portion of the plurality of memory cells 530 are in a low-resistance state, an additional initialization operation to bring the same into a high-resistance state may be additionally required. Each of the plurality of memory cells 530 may have a certain threshold required for change in resistance and/or conductivity. When a voltage or current less than a certain threshold is applied to both ends of each memory cell 530, the conductivity of the memory cell 530 may not change, and when a voltage or current greater than a certain threshold is applied to the memory cell 530, the conductivity of the memory cell 530 may change.

In this state, in order to perform an operation of outputting certain data as a result of the certain column line 522, an input signal corresponding to the certain data (or an analog input obtained by converting an input signal) may enter the row line 512. For example, the input signal may appear as application of an electrical pulse to each row line 512. Additionally, the column line 522 may be driven with an appropriate voltage or current for output.

Hereinafter, for convenience of description, a single bit (1 bit)-operation will be used as an example. In an example, when the column line 522 to output certain data has already been determined, the memory cell 530 located at an intersection of the column line 522 with respect to the row line 512 corresponding to '1' may be driven to receive a voltage greater than or equal to a voltage required during a set operation (hereinafter referred to as set voltage), and the remaining column lines 522 may be driven to allow the remaining memory cells 530 to receive a voltage less than the set voltage. For example, if the amplitude of the set voltage is Vset and a third column line 522C is set as the column line 522 to output data of '0011', in order that first and second memory cells 530A and 530B located at intersections between the third column line 522C and the third and fourth row lines 512C and 512D receive a voltage greater than or equal to Vset, the amplitude of electric pulses applied to the third and fourth row lines 512C and 512D may be greater than or equal to Vset, and a voltage applied to the third column line 522C may be 0 V. Accordingly, the first and second memory cells 530A and 530B may be in a low resistance state. The conductivity of the first and second memory cells 530A and 530B in a low-resistance state may gradually increase as the number of electrical pulses increases. The amplitude and width of the applied electrical pulse may be substantially constant. A voltage applied to the remaining column lines, that is, the first, second, and fourth column lines 522A, 522B, and 522D may have a value between 0 V and Vset, for example, 1/2 Vset, so that the remaining memory cells 530, excluding the first and second memory cells 530A and 530B, receive a voltage less than Vset. Accordingly, the resistance state of the remaining memory cells 530 except the first and second memory cells 530A and 530B may not change.

As another example, the column line 522 to output certain data may not be determined in advance. In this case, while applying an electrical pulse corresponding to certain data, to the row line 512, a current flowing through each of the column lines 522 may be measured and the column line 522 that reaches a certain threshold current first, for example, the third column line 522C, may be the column line 522 that outputs the certain data.

Using the method described above, different data may be output to different column lines 522, respectively.

Meanwhile, the row line 512 of the cell array described above may indicate a word line, and the column line 522 of the cell array may indicate a bit line.

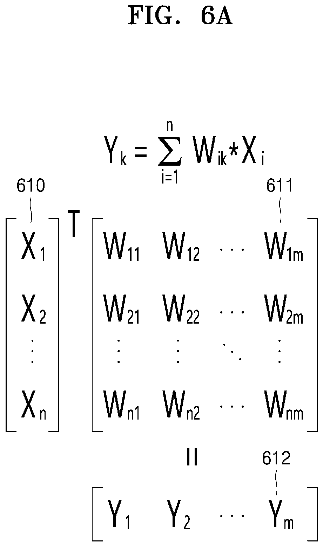

FIGS. 6A to 6B are diagrams for comparing a vector-matrix multiplication and an operation performed on a cell array according to an embodiment.

First, referring to FIG. 6A, a convolution operation between input data and a kernel may be performed using a vector-matrix multiplication. For example, input data may be expressed as a matrix X 610, and weight values may be expressed as a kernel as a matrix W 611. Output data may be expressed as a matrix Y 612, which is a result of a multiplication operation between the matrix X 610 and the matrix W611.

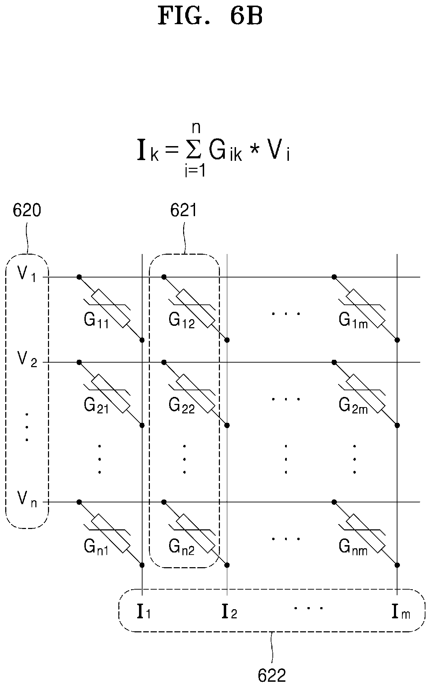

Referring to FIG. 6B, a vector multiplication operation may be performed using a plurality of memory cells of a cell array. Compared with FIG. 6A, input data may be received as an input value of a memory cell, and the input value may be a voltage 620. Additionally, weight values may be stored in a synapse of a core, that is, a memory cell, and the weight values stored in the memory cell may be conductance 621. Accordingly, the output value of the memory cell may be expressed as a current 622, which is the result of a multiplication operation between the voltage 620 and the conductance 621.

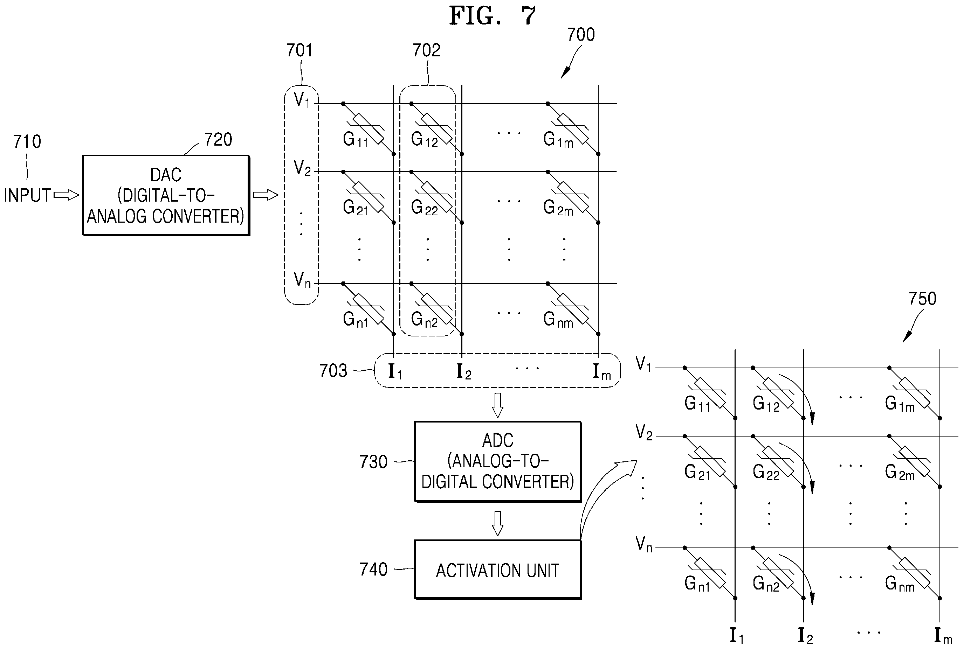

FIG. 7 is a diagram to describe an example in which a convolution operation is performed in a cell array according to an embodiment.

In an embodiment, a neural network device may receive an input signal 710. The input signal 710 may be a digital input with a digital value. The input signal 710 may be converted into an analog input 701 through a digital-to-analog converter 720. Additionally, the analog input 701 may be input to a plurality of word lines of a core 700 implemented as at least a portion of a cell array.

Additionally, the core 700 may store trained kernel values in a plurality of memory cells. For example, the kernel values stored in the plurality of memory cells may be conductance 702. The cell array may output an output value by performing a vector multiplication operation between the analog input 701 and the conductance 702, and the output value may be expressed as an analog output 703 (e.g., a current value).

Since the analog output 703 (e.g., current) output from the core 700 is an analog signal, the analog output 703 may be converted into a digital input by using the analog-to-digital converter 730, in order for the analog output 703 to be used as input data for another core of the cell array. The cell array may convert the analog output 703 into a digital signal by using the analog-to-digital converter 730. In an embodiment, the neural network device may use the analog-to-digital converter 730 to convert the analog output 703 into a digital signal such that the analog output 703 has the same bit resolution as the number of bits of the input signal 710. For example, if the number of bits of the input signal 710 is a 1-bit resolution, the neural network device may convert the analog output 703 into a digital signal with a 1-bit resolution by using the analog-to-digital converter 730.

The neural network device may apply an activation function to the digital signal converted by the analog-to-digital converter 730, by using an activation unit 740. A Sigmoid function, Tanh function, and Rectified Linear Unit (ReLU) function may be used as activation functions, but the activation function applicable to digital signals is not limited thereto. A digital signal to which an activation function is applied may be used as an input value for another core 750. When a digital signal to which an activation function is applied is used as an input value for the other core 750, the above-described process may be applied equally to the other core 750.

The core 700 and the other core 750 may not be physically separate from each other, but the weight values of the memory cells included in the cell array may have been changed according to the weight and/or bias value of each of the core 700 and the core 750.

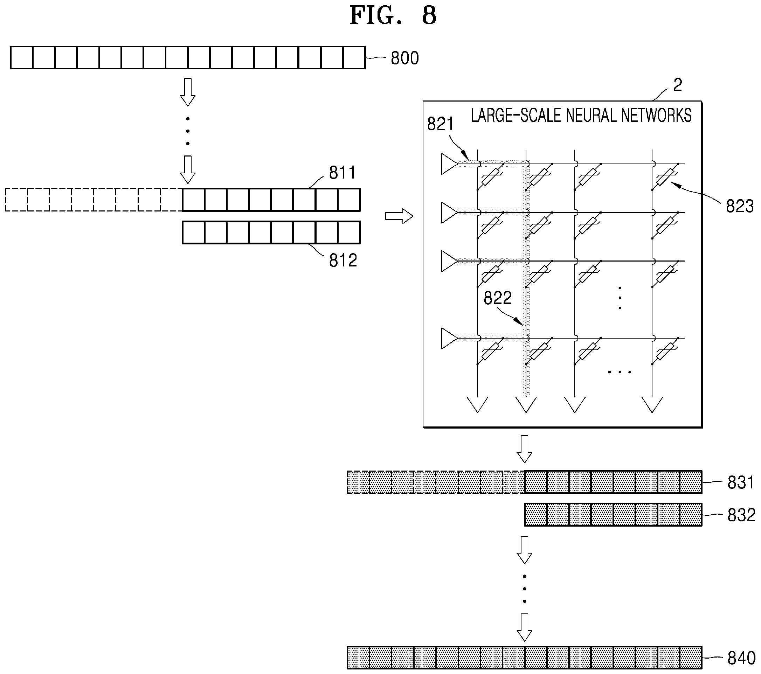

Meanwhile, the number of bits of the input signal 710 may have various bit resolution values, such as 1-bit, 4-bit, and 8-bit resolution. The number of bits of the input signal 710 may be greater than a resolution of the memory cells included in the cell array 700. In this case, an operation may be performed by making the number of bits of the input signal 710 smaller than or equal to a resolution of the memory cells included in the cell array 700, but in this case, a precise operation cannot be performed. Thus, the calculation method for solving this problem will be described in detail with reference to FIG. 8 and below.

FIG. 8 is a diagram to describe a method of operating a neural network device, according to an embodiment of the present disclosure.

FIG. 8 shows an environment in which a processor of a neural network device generates an output signal based on an input signal. That is, in FIG. 8, only components for describing the processor's performance process (for example, the cell array 2) are shown, but the present disclosure is not limited thereto and additional, omitted components may be included.

The processor may be a component of control logic (not shown) included in the neural network device. Alternatively, the processor may be a component provided separately from the control logic (not shown).

In an embodiment, the processor may generate one or more digital inputs 811 and 812 based on an input signal 800. As an example, the processor may input at least one digital input including at least a portion of the input signal 800 to a digital-to-analog converter (not shown), based on the number of bits of the input signal 800 and a bit resolution of the digital-to-analog converter (not shown) (hereinafter referred to as 'DAC bit resolution').

For example, the processor may input the input signal 800 as digital inputs 811 and 812 to the digital-to-analog converter (not shown) based on the number of bits of the input signal 800 and the DAC bit resolution, generate the plurality of digital inputs 811 and 812 including at least a portion of the input signal 800 based on the number of bits of the input signal 800 and the DAC bit resolution, and input the generated plurality of digital inputs 811 and 812 to the digital-to-analog converter (not shown).

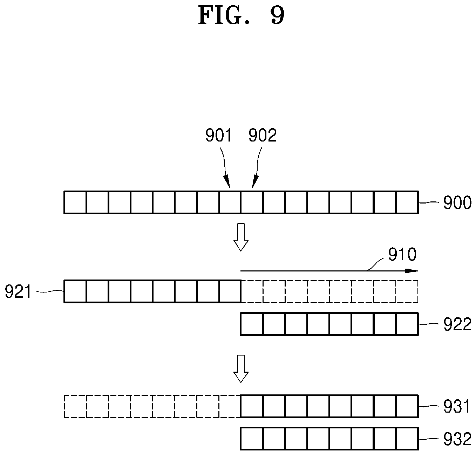

FIG. 9 is a diagram to describe digital input according to an embodiment of the present disclosure.

Referring to FIG. 9, a processor may input two or more digital inputs including at least a portion of an input signal 900 to the digital-to-analog converter in response to the number of bits of the input signal 900 exceeding the DAC bit resolution. For example, in response to the number of bits of the input signal 900 being 16 bits and the DAC bit resolution being 8 bits, the processor may input two or more digital inputs including at least a portion of the input signal 900 to the digital-to-analog converter.

In an embodiment, two or more digital inputs may include an upper bit string 931 corresponding to upper bits 921 of the input signal 900 and a lower bit string 932 corresponding to lower bits 922 of the input signal 900. For example, if the input signal 900 is 16-bit data, the upper bit string 931 may be a bit string corresponding to the upper 8 bits of the input signal 900, and the lower bit string 932 may be a bit string corresponding to the lower 8 bits of the input signal 900. As another example, if the input signal 900 is 16-bit data, the upper bit string 931 may be a bit string corresponding to the upper 10 bits of the input signal 900, and the lower bit string 932 may be a bit string corresponding to the lower 6 bits of the input signal 900. However, in this case, as will be described later, the DAC bit resolution must be 10 bits or more.

A plurality of bits constituting the upper bits 921 of the input signal 900 have a higher position value on average than a plurality of bits constituting the lower bits 922 in the input signal 900. In an embodiment, the upper bits 921 of the input signal 900 may be a bit string from a first bit in a position higher than a reference bit 901, to the reference bit 901, and the lower bits 922 may be a bit string from one of the plurality of bits of the upper bits 921 and a next bit 902 of the reference bit 901 to a second bit in a position lower than the next bit 902 of the reference bit 901.

In an embodiment, when the DAC bit resolution is n and a most significant bit (MSB) of the input signal 900 is a bit of a first position, the reference bit 901 may be a bit of an nth position of the input signal 900. In another embodiment, the reference bit 901 may be any bit between the most significant bit of the input signal 900 and the bit of the nth position.

In an embodiment, the upper bit string 931 may be a string that is obtained by shifting the upper bits 921 of the input signal 900 to the right by a first bit length 910 so that a least significant bit (LSB) of the upper bit string 931 is aligned with a least significant bit of the input signal 900.

The least significant bit refers to a bit located at a lowest position within a bit string. For example, in a bit string (1, 1, 1, 1, 1, 1, 1, 0), the least significant bit may be 0. In addition, that a least significant bit of the upper bit string 931 is aligned with the least significant bit of the input signal 900 may indicate that the remaining bits except for the upper bits 921 of the input signal 900 are removed so that the least significant bit of the upper bit string 931 is located at the same position as the least significant bit of the input signal 900.

In an embodiment, the upper bit string 931 may be a bit string from the most significant bit of the input signal 900 to the reference bit 901, and the lower bit string 932 may be a bit string from one of a plurality of bits of the upper bits 921 of the input signal 900 and of the next bit 902 of the reference bit 901 to the least significant bit of the input signal 900.

The most significant bit refers to a bit located at a highest position within a bit string. For example, in a bit string (1, 0, 0, 0, 0, 0, 0, 0), the most significant bit may be 1.

As an example, if the lower bit string 932 is a bit string from the next bit 902 of the reference bit 901 to the least significant bit of the input signal 900, the first bit length 910 may be the number of bits of the lower bit string 932. That is, if the lower bit string 932 is a bit string from the next bit 902 of the reference bit 901 to the least significant bit of the input signal 900, the upper bit string 931 and the lower bit string 932 are results of dividing the input signal 900 without overlapping bits, and thus the first bit length 910 may be the number of bits of the lower bit string 932. FIG. 9 shows a case where the input signal 900 is divided in half to generate the upper bit string 931 and the lower bit string 932, but the number of bits of the upper bit string 931 and the lower bit string 932 may be different depending on the position of the reference bit 901.

For example, when the input signal 900 has 16 bits and is (1, 1, 0, 1, 0, 0, 0, 1, 1, 1, 1, 1, 0, 0, 1, 0) and a reference bit is 1 of the 9th digit, the upper bit string 931 may be (1, 1, 0, 1, 0, 0, 0, 1), from which the remaining bits (1, 1, 1, 1, 0, 0, 1, 0) are excluded except for the upper bits of the input signal 900, and the lower bit string 932 may be a bit string (1, 1, 1, 1, 0, 0, 1, 0) from 1, which is the next bit to the reference bit, to the least significant bit.

The number of bits of a digital input may be less than or equal to the DAC bit resolution. That is, according to an embodiment of the present disclosure, even when an input signal with a higher number of bits than the DAC bit resolution is input, the processor may generate two or more digital inputs of a bit number of two or more bits, which is equal to or less than the DAC bit resolution (for example, 931, 932) and input the digital inputs into a digital-to-analog converter.

Returning back to FIG. 8, the one or more digital inputs 811 and 812 may be input to a plurality of word lines 821 of the cell array 2 through a digital-to-analog converter (not shown). The one or more digital inputs 811 and 812 input to the plurality of word lines 821 of the cell array 2 may be output as an analog output through calculation with the weights of the neural network stored in the plurality of memory cells 823. This analog output may be output through a bit line 822 of the cell array 2. That is, the processor may obtain digital outputs 831 and 832 corresponding to an output of the bit line 822. The digital outputs 831 and 832 respectively corresponding to the digital inputs 811 and 812 may be obtained. For example, sequentially, the digital output 831 corresponding to the digital input 811 and the digital output 832 corresponding to the digital input 812 may be obtained.

For example, a first analog output that is first output through the bit line 822 may be converted into the digital output 831 through an analog-to-digital converter, and a second analog output subsequently output through the bit line 822 may be converted into the digital output 832 through the analog-to-digital converter. The processor may sequentially obtain the digital output 831 and the digital output 832 which are output through the analog-to-digital converter.

In an embodiment, when the digital input 811 is an upper bit string according to the above-described embodiment and the digital input 812 is a lower bit string according to the above-described embodiment, the processor may input the upper bit string 811 and the lower bit string 812 into a digital-to-analog converter (not shown), and receive the digital output 831 corresponding to the upper bit string 811 and the digital output 832 corresponding to the lower bit string 812, which are output through an analog-to-digital converter (not shown). In the following description, the digital output 831 corresponding to the upper bit string 811 may be defined as an upper bit output, and the digital output 832 corresponding to the lower bit string 812 may be defined as a lower bit output.

In an embodiment, the processor may generate an output signal 840 by using at least one of the digital outputs 831 and 832, the one corresponding to an output of the bit line 822, based on the number of bits of the input signal 800 to be obtained and a bit resolution of the plurality of memory cells 823 (hereinafter referred to as 'cell bit resolution').

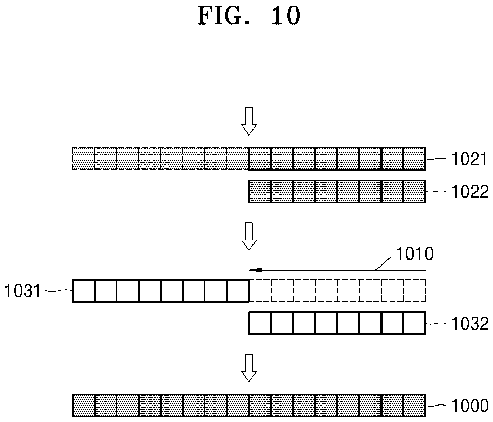

FIG. 10 is a diagram to describe a method of generating an output signal, according to an embodiment of the present disclosure.

Referring to FIG. 10, an upper bit output 1021 and a lower bit output 1022 according to an embodiment are shown. In an embodiment, the processor may shift the upper bit output 1021 to the left by a first bit length 1010. For example, if the upper bit output 1021 is (1, 1, 0, 1, 0, 0, 0, 1), the upper bit output 1031 shifted to the left by the first bit length 1010 may be (1, 1, 0, 1, 0, 0, 0, 1, 0, 0, 0, 0, 0, 0, 0, 0). Here, "0" in the lower 8 bits may actually represent a value 0, but may also be replaced with a meaningless value or an empty value (null).

In an embodiment, the processor may generate an output signal 1000 based on the upper bit output 1031 that is shifted and the lower bit output 1032. For example, if the shifted upper bit output 1031 is (1, 1, 0, 1, 0, 0, 0, 1, 0, 0, 0, 0, 0, 0, 0, 0) and the lower bit output 1032 is (1, 1, 1, 1, 0, 0, 1, 0), the processor may combine the upper bit output 1031 with the lower bit output 1032 to generate (1, 1, 0, 1, 0, 0, 0, 1, 1, 1, 1, 1, 0, 0, 1, 0) as the output signal 1000. That is, the output signal 1000 may be generated by filling the lower bit output 1032 corresponding to the first bit length 1010, into lower bits corresponding to the first bit length 1010 of the upper bit output 1031.

Returning to FIG. 9, as an example, when the lower bit string 932 is a bit string from the next bit 902 to the reference bit 901 to the least significant bit of the input signal 900, the first bit length 910 may be the number of bits of the lower bit string 932. That is, if the lower bit string 932 is a bit string from the next bit 902 to the reference bit 901 to the least significant bit of the input signal 900, the upper bit string 931 and the lower bit string 932 are results of dividing the input signal 900 without overlapping bits, and thus the first bit length 910 may be the number of bits of the lower bit string 932.

FIG. 9 shows a case where the input signal 900 is divided in half to generate the upper bit string 931 and the lower bit string 932, but the number of bits of the upper bit string 931 and the lower bit string 932 may be different depending on the position of the reference bit 901.

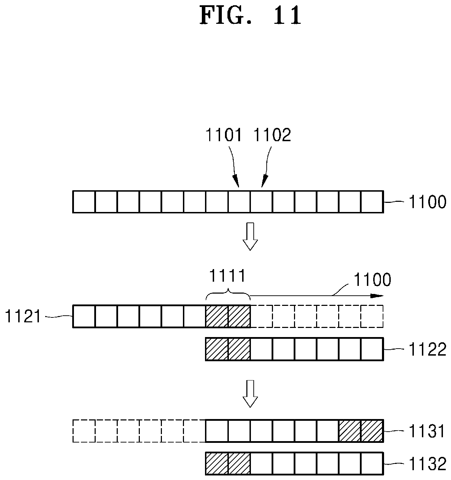

FIG. 11 is a diagram to describe a digital input according to another embodiment of the present disclosure.

In an embodiment, when a lower bit string 1132 is a bit string from any one of a plurality of bits of the upper bit 1121 of an input signal 1100 to a least significant bit of the input signal 1100, a first bit length 1110 may be a value obtained by subtracting the number of overlapping bits 1111 of an upper bit string 1131 and the lower bit string 1132 from the number of bits of the lower bit string 1132.

As an example, in order for the upper bit string 1131 and the lower bit string 1132 not to overlap each other, the processor needs to determine a bit string from a next bit 1102 to the reference bit 1101 to the least significant bit of the input signal 1100, as the lower bit string 1132. Conversely, the processor may determine the upper bit string 1131 and the lower bit string 1132 to overlap each other.

For example, when the upper bit string 1131 is a bit string from a most significant bit of the input signal 1100 to the reference bit 1101, and the lower bit string 1132 is a bit string from one of a plurality of bits of the upper bit string 1121 of the input signal 1100 to the least significant bit of the input signal 1100, the upper bit string 1131 and the lower bit string 1132 may have overlapping bits 1111. As illustrated in FIG. 11, when the lower bit string 1132 is a bit string from a previous bit of the reference bit 1101 to the least significant bit of the input signal 1100, the upper bit string 1131 and the lower bit string 1132 may have two overlapping bits 1111.

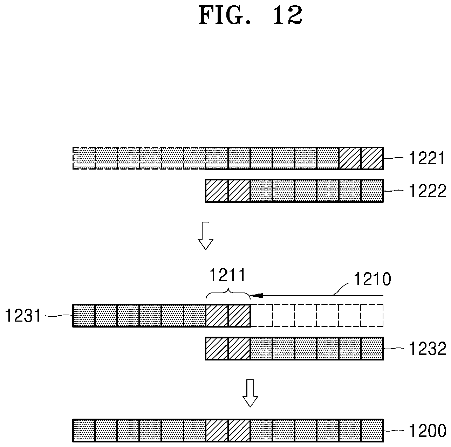

FIG. 12 is a diagram to describe a method of generating an output signal, according to another embodiment of the present disclosure.

Referring to FIG. 12, an embodiment is illustrated, in which, when an upper bit string and a lower bit string have overlapping bits as illustrated in FIG. 11, the processor generates an output signal 1200 based on an upper bit output 1221 corresponding to the upper bit string and a lower bit output 1222 corresponding to the lower bit string.

In an embodiment, the processor may shift the upper bit output 1221 corresponding to the upper bit string to the left by a first bit length 1210. As described above, the first bit length 1210 may be a value obtained by subtracting the number of overlapping bits of the upper bit string and the lower bit string from the number of bits of the lower bit string.

In an embodiment, the processor may generate the output signal 1200 based on the upper bit output 1231 that is shifted and the lower bit output 1232. The method by which the processor generates the output signal 1200 based on the shifted upper bit output 1231 and the lower bit output 1232 is the same as that of FIG. 10, but there may be problem in a method performed by the processor processing the overlapping bits 1211 when combining the upper bit output 1221 with the lower bit output 1232 of the embodiment.

In an embodiment, the overlapping bits 1211 of the upper bit output 1221 and the overlapping bits 1211 of the lower bit output 1222 may not have the same values. As a result of an operation of a cell array on certain data, errors in certain lower bits tend to be ignored. However, since the upper bit output 1221 becomes upper bits of the output signal 1200 when generating the output signal 1200, lower bits of the upper bit output 1221 needs to be preserved. Therefore, as described with reference to FIG. 11, the processor may generate an upper bit string and a lower bit string such that there are overlapping bits between the upper bit string and the lower bit string, and may preserve the lower bits of the upper bit output 1221 as described above by replacing the overlapping bits 1211 of the upper bit output 1221 corresponding to the upper bit string, with a value of the overlapping bits 1211 of the lower bit output 1222 corresponding to the lower bit string.

However, the method of processing the overlapping bits 1211 is not limited thereto, and the output signal 1200 may be determined based on a difference value between the overlapping bits 1211 of the upper bit output 1221 and the overlapping bits 1211 of the lower bit output 1222. For example, a corresponding portion of the output signal 1200 may be determined by an average value of the overlapping bits 1211 of the upper bit output 1221 and the overlapping bits 1211 of the lower bit output 1222.

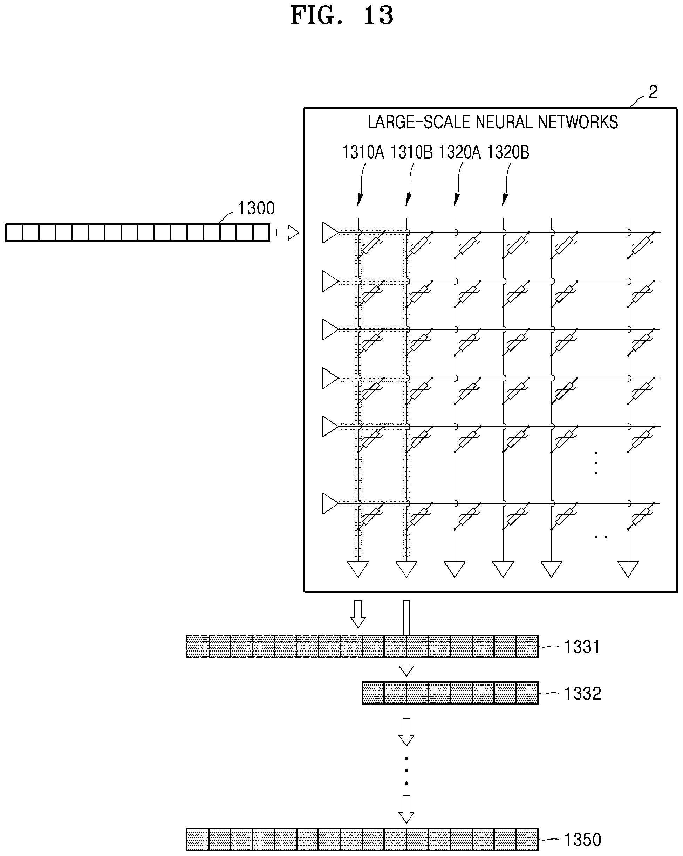

FIG. 13 is a diagram to describe a method of operating a neural network device, according to another embodiment of the present disclosure.

FIG. 13 illustrates an environment in which a processor of a neural network device generates an output signal 1350 based on an input signal 1300. That is, in FIG. 13, only components for describing the processor's performance process (for example, the cell array 2) are shown, but the present disclosure is not limited thereto and additional, omitted components may be further included.

In an embodiment, the processor may generate the output signal 1350 by combining any two or more combinations of digital outputs 1331 and 1332 generated based on the input signal 1300. In response to the number of bits of the input signal 1300, the number exceeding a cell bit resolution, the processor may generate the output signal 1350 by combining any two or more combinations of the digital outputs 1331 and 1332 corresponding to outputs of bit lines 1310A, 1310B, 1320A, and 1320B. That is, in response to the number of bits of the input signal 1300, the DAC bit resolution being 16 bits, and the cell bit resolution being 8 bits, the processor may generate the output signal 1350 by combining any two or more combinations of the digital outputs 1331, 1332 corresponding to the outputs of the bit lines 1310A, 1310B, 1320A, and 1320B.

Meanwhile, the number of bits of the digital outputs 1331 and 1332 may be equal to or smaller than the cell bit resolution. That is, according to an embodiment of the present disclosure, the processor may combine any two or more combinations of digital outputs 1331 and 1332 with a bit number less than or equal to the cell bit resolution to generate an output signal having a higher bit number than the cell bit resolution.

In an embodiment, the cell array 2 may include a pair consisting of a first bit line 1310A to which a first memory cell storing weights corresponding to the upper bits of the output signal 1350 is connected and a second bit line 1310B to which a second memory cell storing weights corresponding to the lower bits of the output signal 1350 is connected. Additionally, in an embodiment, the digital outputs 1331 and 1332 corresponding to the outputs of the first and second bit lines 1310A and 1310B may include an upper bit output 1331 corresponding to the output of the first bit line 1310A and a lower bit output 1332 corresponding to the output of the second bit line 1310B. Accordingly, the processor may generate the output signal 1350 based on the digital output 1331 output from the first bit line 1310A and the digital output 1332 output from the second bit line 1310B.

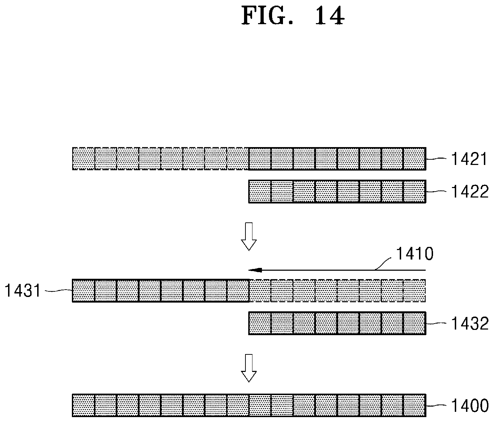

FIG. 14 is a diagram to describe a method of generating an output signal, according to an embodiment of the present disclosure.

Referring to FIG. 14, an upper bit output 1421 and a lower bit output 1422 according to an embodiment are shown. In an embodiment, the processor may shift the upper bit output 1421 to the left by a second bit length 1410. For example, in an embodiment in which the processor moves the upper bit output 1421 to the left by the second bit length 1410, the same method as that of the embodiment described above with reference to FIG. 10, in which the processor moves the upper bit output to the left by the first bit length, may be applied.

Specifically, the processor may shift the upper bit output 1421 to the left by the second bit length 1410 so that a most significant bit of the upper bit output 1421 is aligned with a most significant bit of the output signal 1400, and generate the output signal 1400 based on the shifted upper bit output 1431 and the lower bit output 1432. For example, the processor may generate the output signal 1400 by combining the upper bit output 1431 and lower bit output 1432.

Referring back to FIG. 13, in an embodiment, the first bit line 1310A may store weights of upper bits from a most significant bit of the output signal 1350 to a reference bit (not shown), and the second bit line 1310B may store weights of lower bits from one of the plurality of upper bits of the output signal 1350 and a next bit (not shown) to the reference bit (not shown) to the least significant bit of the output signal 1350. Accordingly, the output of the first bit line 1310A may be an upper bit output (e.g., the digital output 1331), and the output of the second bit line 1310B may be a lower bit output (e.g., digital output 1332).

Referring back to FIG. 14, in an embodiment, when a second bit line stores weights of lower bits from a bit next to a reference bit (not shown) to a least significant bit of the output signal 1400, the second bit length 1410 may be the number of bits of the lower bit output 1422. In this regard, the principle described above with reference to FIG. 10 may be applied as is.

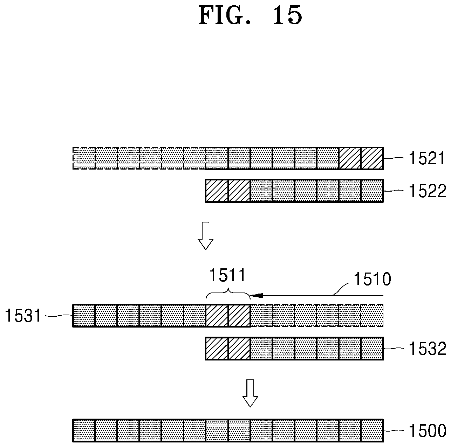

FIG. 15 is a diagram to describe a method of generating an output signal, according to another embodiment of the present disclosure.

In an embodiment, when a second bit line stores weights of lower bits from any one of a plurality of upper bits of the output signal 1500 to a least-significant bit of the output signal 1500, a second bit length 1510 may be a value obtained by subtracting the number of overlapping bits 1511 of an upper bit output 1521 and a lower bit output 1522 from the number of bits of the lower bit output 1522.

In an embodiment, the processor may calculate an operation result (hereinafter referred to as ground truth output') of an upper bit string and weights of a neural network, stored in a plurality of memory cells of a cell array. The processor may define a difference between the ground truth output and the upper bit output 1521 as a residual error, and reflect the residual error in the weights of the second bit line that outputs the lower bit output 1522. That is, the processor may preserve the overlapping bits 1511 of the upper bit output 1521 by replacing values of the overlapping bits 1511 of the upper bit output 1521 with values of the overlapping bits 1511 of the lower bit output 1522.

The same principle as the method described above with reference to FIG. 14 may be applied to a method in which the processor combines the shifted upper bit output 1531 and the lower bit output 1532 to generate the output signal 1500, and details thereof will be omitted.

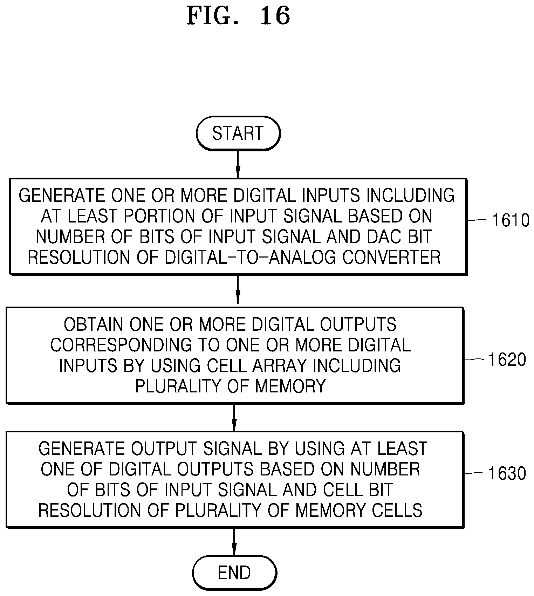

FIG. 16 is a flowchart of a method of operating a neural network device, according to an embodiment of the present disclosure.

Referring to FIG. 16, in operation 1610, the neural networkdevice may generate one or more digital inputs including at least a portion of an input signal based on the number of bits of the input signal and a DAC bit resolution of a digital-to-analog converter.

In an embodiment, the neural network device may generate, in response to the number of bits of the input signal, the number exceeding the DAC bit resolution of the digital-to-analog converter, two or more digital inputs including at least a portion of the input signal and input the digital inputs to the digital-to-analog converter.

In an embodiment, the number of bits of a digital input may be equal to or greater than the DAC bit resolution.

In an embodiment, two or more digital inputs may include an upper bit string corresponding to upper bits of the input signal and a lower bit string corresponding to lower bits of the input signal.

In an embodiment, the upper bit string may include the upper bits of the input signal, shifted to the right by a first bit length so that a least significant bit of the upper bit string is aligned with a least significant bit of the input signal.

In an embodiment, the neural network device may input the upper bit string and the lower bit string to the digital-to-analog converter.

In an embodiment, the upper bit string may include a bit string from a most significant bit of the input signal to a reference bit, and the lower bit string may include a bit string from any one of a plurality of bits of the upper bits of the input signal and a next bit to the reference bit, up to the least significant bit of the input signal.

In an embodiment, when the lower bit string is a bit string from the next bit of the reference bit to the least significant bit of the input signal, the first bit length may be the number of bits of the lower bit string.

In an embodiment, when the lower bit string is a bit string from any one of the plurality of bits of the upper bits of the input signal to the least significant bit of the input signal, the first bit length may be a value obtained by subtracting the number of overlapping bits of the upper bit string and the lower bit string from the number of bits of the lower bit string.

In operation 1620, the neural network device may obtain one or more digital outputs corresponding to one or more digital inputs by using a cell array including a plurality of memory cells that store a weight of a neural network.

In operation 1630, the neural network device may generate an output signal by using at least one of the digital outputs based on the number of bits of the input signal and a cell bit resolution of the plurality of memory cells.

In an embodiment, the neural network device may receive an upper bit output corresponding to an upper bit string and a lower bit output corresponding to a lower bit string, the bit outputs being output through an analog-to-digital converter, and shift the upper bit output to the left by a first bit length, and generate an output signal based on the shifted upper bit output and the shifted lower bit output.

In an embodiment, in response to the number of bits of the input signal, the number of bits exceeding the cell bit resolution of the plurality of memory cells, the neural network device may generate an output signal by combining a combination of any two or more of the digital outputs corresponding to an output of a bit line. The number of bits of a digital output may be equal to or smaller than the cell bit resolution.

In an embodiment, the cell array of the neural network device may include a pair consisting of a first bit line for storing weights corresponding to upper bits of the output signal and a second bit line for storing weights corresponding to lower bits of the output signal.

In an embodiment, the digital output corresponding to the output of the bit line may include an upper bit output corresponding to an output of the first bit line and a lower bit output corresponding to an output of the second bit line.

In an embodiment, the neural network device may shift the upper bit output to the left by a second bit length so that a most significant bit of the upper bit output is aligned with a most significant bit of the output signal, and generate an output signal based on the shifted upper bit output and the lower bit output.

In an embodiment, the first bit line may store weights of upper bits from the most significant bit of the output signal to the reference bit.

In an embodiment, the second bit line may store weights of lower bits from any one of a plurality of bits of the upper bits of the output signal and a next bit of the reference bit to a least significant bit of the output signal.

In an embodiment, when the second bit line stores the weights of lower bits from the next bit of the reference bit to the least significant bit of the output signal, the second bit length may be equal to the number of bits of the lower bit output.

In an embodiment, when the second bit line stores the weights of lower bits from any one of a plurality of bits of the upper bits of the output signal to the least significant bit of the output signal, the second bit length may be a value obtained by subtracting the number of overlapping bits of the upper bit output and the lower bit output from the number of bits of the lower bit output.

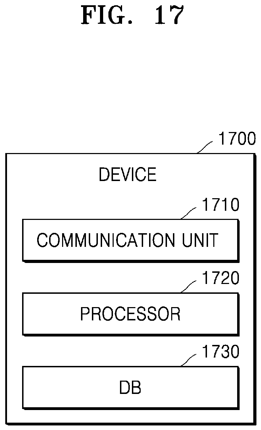

FIG. 17 is a block diagram of a neural network device according to another embodiment of the present disclosure.

Referring to FIG. 17, a neural network device (hereinafter referred to as 'device') 1700 may include a communication unit 1710, a processor 1720, and a database (DB) 1730. In the device 1700 of FIG. 17, only components related to the embodiment are shown. Accordingly, it will be understood by those skilled in the art that other general-purpose components may be included in addition to the components illustrated in FIG. 17.

The communication unit 1710 may include one or more components that enable wired/wireless communication with an external server or external device. For example, the communication unit 1710 may include at least one of a short-range communication unit (not shown), a mobile communication unit (not shown), and a broadcast receiver (not shown). In an embodiment, the communication unit 1710 may use at least one communication protocol of a serial peripheral interface (SPI) and a universal unsynchronized transmitter/receiver (UART). Additionally, in an embodiment, the communication unit 1710 may communicate with sensors, external memory, and an external control device.

The DB 1730 is hardware that stores various data processed within the device 1700, and may store programs for processing and control of the processor 1720.

The DB 1730 may include a random-access memory (RAM) such as dynamic random-access memory (DRAM), static random-access memory (SRAM), read-only memory (ROM), electrically erasable programmable read-only memory (EEPROM), CD-ROM, Blu-ray or other optical disk storage, a hard disk drive (HDD), a solid-state drive (SSD), or flash memory.

The processor 1720 controls the overall operation of the device 1700. For example, the processor 1720 may generally control an input unit (not shown), a display (not shown), the communication unit 1710, the DB 1730, etc. by executing programs stored in the DB 1730. The processor 1720 may control the operation of the device 1700 by executing the programs stored in the DB 1730.

The processor 1720 may control at least some of the operations of the components of the device 1700 described above with reference to FIGS. 1 to 16.

The processor 1720 may be implemented using at least one of application specific integrated circuits (ASICs), digital signal processors (DSPs), digital signal processing devices (DSPDs), programmable logic devices (PLDs), field programmable gate arrays (FPGAs), controllers, microcontrollers, microprocessors, and other electrical units for performing functions.

In an embodiment, the device 1700 may be a server. The server may be implemented using a computer device that communicates through a network to provide commands, codes, files, contents, services, and the like, or a plurality of the computer devices. As an example, the server may receive an input signal and generate an output signal.

According to the problem-solving means of the present disclosure described above, operations may be performed on data having a higher number of bits than a limited bit resolution of a digital-to-analog converter.

In addition, according to the problem-solving means of the present disclosure, an output having a higher number of bits than a limited bit resolution of a memory cell may be generated.

The effects of the embodiments are not limited to the effects stated above, and other effects not stated will be clearly understood by those skilled in the art from the description of the present disclosure.

The embodiments according to the present disclosure described above may be implemented in the form of a computer program that can be executed through various components on a computer, and such a computer program may be recorded in a computer-readable medium. The media may include magnetic media such as hard disks, floppy disks, and magnetic tapes, optical recording media such as CD-ROMs and DVDs, magneto-optical media such as floptical disks, and hardware devices specifically configured to store and execute program instructions, such as ROM, RAM, flash memory, etc.

The computer program may be specifically designed and configured for the embodiments of the present disclosure or may be well-known and available to one of ordinary skill in the art. Examples of the computer program may include not only machine codes generated by using a compiler but also high-level language codes that may be executed on a computer by using an interpreter or the like.

According to an embodiment, methods according to various embodiments of the present disclosure may be included and provided in a computer program product. Computer program products are commodities and may be traded between sellers and buyers. The computer program product may be distributed in the form of a machine-readable storage medium (e.g. compact disc read only memory (CD-ROM)) or through an application store (e.g. Play Store^{™}) or distributed in person or online (e.g., downloaded or uploaded) between two user devices. In the case of online distribution, at least a portion of the computer program product may be at least temporarily stored or temporarily created in a machine-readable storage medium, such as the memory of a manufacturer's server, an application store's server, or a relay server.

Unless there is an explicit order or statement to the contrary regarding the steps constituting the method according to the present disclosure, the steps may be performed in any suitable order. The embodiments are not necessarily limited by the order of description of the steps above. The use of all examples or illustrative terms in the embodiments is simply for describing the embodiments in detail, and the scope of the present disclosure is not limited by the examples or illustrative terms unless limited by the claims. Additionally, those skilled in the art will recognize that various modifications, combinations and changes may be made according to design conditions and factors within the scope of the appended claims or their equivalents.

Therefore, the spirit of the present disclosure is defined not by the detailed description of the present disclosure but by the appended claims, and all differences within the scope will be construed as being included in the present disclosure.

## Claims

1. A neural network device comprising:
a digital-to-analog converter configured to convert a digital input to an analog input of either voltage or current;
a cell array comprising a plurality of memory cells arranged in a plurality of bit lines and a plurality of word lines and configured to store a weight of a neural network, and configured to perform an operation on the analog input that is input through the word lines and output an analog output of any one of current and voltage, through the bit lines;
an analog-to-digital converter configured to convert the analog output into a digital output; and
at least one processor electrically connected to the digital-to-analog converter and the analog-to-digital converter and configured to control the digital input and the digital output,
wherein the at least one processor is further configured to,
based on a number of bits of the input signal and a digital-to-analog converter (DAC) bit resolution of the digital-to-analog converter, input one or more digital inputs including at least a portion of the input signal, to the digital-to-analog converter, and
based on the number of bits of the input signal and a cell bit resolution of the plurality of memory cells, generate an output signal by using at least one of digital outputs corresponding to an output of the bit lines.

2. The neural network device of claim 1, wherein the at least one processor is further configured to input, in response to the number of bits of the input signal, the number of bits exceeding the DAC bit resolution of the digital-to-analog converter, two or more digital inputs including at least a portion of the input signal, to the digital-to-analog converter, and
a number of bits of the digital input is equal to or less than the DAC bit resolution.

3. The neural network device of claim 2, wherein the two or more digital inputs comprise an upper bit string corresponding to upper bits of the input signal and a lower bit string corresponding to lower bits of the input signal,
the upper bit string comprises the upper bits of the input signal, which are shifted to the right by a first bit length so that a least significant bit (LSB) of the upper bit string is aligned with a LSB of the input signal.

4. The neural network device of claim 3, wherein the at least one processor is further configured to input the upper bit string and the lower bit string into the digital-to-analog converter,
receive an upper bit output corresponding to the upper bit string and a lower bit output corresponding to the lower bit string, which are output through the analog-to-digital converter,
shift the upper bit output to the left by the first bit length, and
generate the output signal based on the shifted upper bit output and the lower bit output.

5. The neural network device of claim 3, wherein the upper bit string comprises a bit string from a most significant bit (MSB) of the input signal to a reference bit,
the lower bit string comprises a bit string from any one of a plurality of upper bits of the input signal and a next bit to the reference bit to the LSB of the input signal.

6. The neural network device of claim 5, wherein, when the lower bit string comprises a bit string from the next bit to the reference bit to the LSB of the input signal, the first bit length is a number of bits of the lower bit string.

7. The neural network device of claim 5, wherein, when the lower bit string comprises a bit string from any one of the plurality of bits of the upper bits of the input signal to the LSB of the input signal, the first bit length is a value obtained by subtracting a number of overlapping bits of the upper bit string and the lower bit string from the number of bits of the lower bit string.

8. The neural network device of claim 1, wherein the at least one processor is further configured to generate, in response to the number of bits of the input signal, the number of bits exceeding the cell bit resolution of the plurality of memory cells, an output signal by combining any two or more combinations of digital outputs corresponding to the output of the bit line, and
the number of bits of the digital output is equal to or less than the cell bit resolution.

9. The neural network device of claim 8, wherein the cell array comprises a pair of a first bit line storing a weight corresponding to upper bits of the output signal and a second bit line storing a weight corresponding to lower bits of the output signal, and
the digital output corresponding to the output of the bit line comprises an upper bit output corresponding to an output of the first bit line and a lower bit output corresponding to an output of the second bit line.

10. The neural network device of claim 9, wherein the at least one processor is further configured to shift the upper bit output to the left by a second bit length so that a most significant bit of the upper bit output is aligned with a most significant bit of the output signal, and
generate the output signal based on the shifted upper bit output and the lower bit output.

11. The neural network device of claim 10, wherein the first bit line stores weights of the upper bits from the most significant bit of the output signal to a reference bit, and
the second bit line stores weights of the lower bits from any one of a plurality of upper bits of the output signal and a next bit to the reference bit to a least significant bit of the output signal.

12. The neural network device of claim 11, wherein, when the second bit line stores the weights of lower bits from the next bit to the reference bit to the least significant bit of the output signal, the second bit length is the number of bits of the lower bit output.

13. The neural network device of claim 11, wherein, when the second bit line stores weights of lower bits from any one of a plurality of bits of the upper bit of the output signal to the least significant bit of the output signal, the second bit length is a value obtained by subtracting the number of overlapping bits of the upper bit output and the lower bit output from the number of bits of the lower bit output.

14. An operating method of a neural network device, the method comprising:
generating, based on a number of bits of an input signal and a digital-to-analog converter (DAC) bit resolution of a digital-to-analog converter, one or more digital inputs including at least a portion of the input signal;
obtaining one or more digital outputs corresponding to the one or more digital inputs by using a cell array comprising a plurality of memory cells that store a weight of a neural network; and
generating an output signal by using at least one of the digital outputs, based on the number of bits of the input signal and a cell bit resolution of the plurality of memory cells.

15. A computer-readable recording medium having recorded thereon a program for causing the method of claim 14 to execute on a computer.
